# FASCICULE DE BREVET EUROPEEN

(11) **EP 2 994 813 B1**
(45) Date de publication et mention de la délivrance du brevet: **20.02.2019**
(21) Numéro de dépôt: 14722181.6
(22) Date de dépôt: 05.05.2014
(51) Int. Cl.: G06F 3/0346, G06F 3/038

(54) **PROCEDE DE COMMANDE D'UNE INTERFACE GRAPHIQUE POUR AFFICHER DES IMAGES D'UN OBJET TRIDIMENSIONNEL**
VERFAHREN ZUR STEUERUNG EINER GRAFISCHEN SCHNITTSTELLE ZUR ANZEIGE VON BILDERN EINES DREIDIMENSIONALEN OBJEKTS
METHOD FOR CONTROLLING A GRAPHICAL INTERFACE FOR DISPLAYING IMAGES OF A THREE-DIMENSIONAL OBJECT

(30) Priorité: 07.05.2013 FR 1354157
(43) Date de publication de la demande: 16.03.2016
(73) Titulaire: Commissariat à l'Energie Atomique et aux Energies Alternatives, 75015 Paris (FR)
(72) Inventeur: HAUTSON, Tristan, F-38600 Fontaine (FR); JOBERT, Timothée, F-38000 Grenoble (FR)
(74) Mandataire: Colombo, Michel
(86) Numéro de dépôt international: PCT/EP2014/059140
(87) Numéro de publication internationale: WO 2014/180797

(56) Documents cités:
- WO-A1-2011/043645
- FR-A1- 2 586 302
- US-A- 5 687 307
- US-A1- 2006 061 354
- US-A1- 2009 174 714

## Description

L'invention concerne un procédé et un appareil de commande d'une interface graphique pour afficher des images d'un objet tridimensionnel. Elle a également pour objet un support d'enregistrement d'informations pour la mise en oeuvre de ce procédé.

Il existe aujourd'hui de plus en plus de fichiers numériques codant des objets tridimensionnels et de plus en plus d'applications utilisant de tels fichiers. Par exemple, les logiciels de conception assistée par ordinateur (CAO) permettent de générer de tel fichiers. Le service « Google Earth »® permettant d'observer depuis le ciel le globe terrestre est un exemple d'une application utilisant un tel fichier. On peut également citer l'application « Google Street View »® qui permet d'afficher ce qu'un piéton pourrait voir en se promenant dans les rues d'une ville.

Un objet tridimensionnel est un objet dont la position de chaque point dans un espace à trois dimensions est fonction de trois coordonnées dans cet espace. Un objet tridimensionnel n'est pas nécessairement en « relief ». Il peut aussi s'agir d'une image plane dont la position de chaque point de l'image dans l'espace à trois dimensions est fonction des trois coordonnées de ce point dans l'espace à trois dimensions.

Un fichier numérique est considéré comme codant un objet tridimensionnel si ce fichier contient suffisamment d'informations pour déterminer, à partir de ces seules informations, la position de chacun des points de l'objet dans un repère tridimensionnel. Dans ce repère tridimensionnel, la position de chacun des points de l'objet est donnée par trois coordonnées. Ici, le repère utilisé pour coder la position des points de l'objet tridimensionnel dans le fichier est appelé par la suite repère « virtuel ».

Un repère tridimensionnel est un repère dont les axes forment typiquement un trièdre.

Un fichier numérique peut prendre la forme d'une base de données. Il peut aussi être fractionné en de multiple parties enregistrées à différents endroits.

En pratique, pour construire à partir d'un tel fichier une image en deux dimensions destinée à être affichée sur un écran, il faut connaître :
- la position du point de vue,
- la direction de l'axe optique, et
- le champ de prise de vue.

Le champ de prise de vue définit les limites extérieures de l'image en deux dimensions construite. Le champ de prise de vue est typiquement défini par un ou deux angles de prise de vue ou angle de champ. L'angle A de prise de vue est souvent défini par la relation suivante : tan(A/2) = l/2f, où
- l est une dimension de l'image en deux dimensions, et
- f est la distance focale de l'objectif utilisé.

L'axe optique correspond à la ligne de visée d'un appareil photo ou d'une caméra. Il est donc confondu avec les bissectrices des angles de prise de vue.

Aujourd'hui, de tels algorithmes permettant de construire une image en deux dimensions à partir d'un objet tridimensionnel codé dans un fichier sont bien connus et fonctionnent rapidement. En fait, la difficulté qu'il reste à résoudre est surtout de trouver un moyen simple et intuitif permettant à un utilisateur de spécifier les trois paramètres que sont :
- la position du point de vue,
- la direction de l'axe optique, et
- les angles de prise de vue.

A ce jour, pour simplifier les interactions avec les utilisateurs, les angles de prise de vue sont généralement pris égaux à des constantes. De même, souvent, l'un ou l'autre de la position du point de vue et de la direction de l'axe optique sont pris égal à une constante. Toutefois, malgré ces simplifications, l'affichage d'une image en deux dimensions construite à partir d'un objet tridimensionnel codé dans un fichier reste une tâche difficile pour un utilisateur. En effet, il n'est pas facile pour cet utilisateur d'indiquer précisément et simplement la position du point de vue ou la direction de l'axe optique.

De l'état de la technique est connu de : US5687307A, US2006/061354A1, FR2586302A1, WO2011/174714A1. US5687307A décrit un procédé dans lequel une image en deux dimensions est construite à partir d'un fichier codant un objet tridimensionnel. Ce procédé utilise une souris équipé d'une boule déplaçable dans plusieurs directions pour modifier les coordonnées d'un point de vue et la direction d'un axe optique. US2006/061354A1 décrit une interface homme-machine pour acquérir la position d'un aimant permanent.

L'invention vise à remédier à cet inconvénient. A cet effet, elle a pour objet un procédé de commande d'une interface graphique conforme à la revendication 1.

Le procédé ci-dessus permet à un utilisateur d'indiquer très simplement et de façon très intuitive la position du point de vue et/ou la direction de l'axe optique pour obtenir une image en deux dimensions de l'objet tridimensionnel codé dans le fichier.

L'utilisation d'un aimant permanent simplifie la réalisation du pointeur manipulé par l'utilisateur car il n'est pas nécessaire d'alimenter ce pointeur pour générer un champ magnétique. De plus, puisque le moment magnétique d'un aimant permanent est orienté, il est facile d'identifier la direction dans laquelle l'utilisateur souhaite observer l'objet tridimensionnel.

Enfin, le choix du coefficient Cₑ strictement inférieur à d_{Z}/dₘₐₓ garantit que, lors de la mise en correspondance des dimensions de l'objet tridimensionnel avec celles de la zone de mesure, l'objet tridimensionnel est entièrement situé à l'intérieur de cette zone de mesure. Dès lors, cela permet à l'utilisateur, sans difficulté, de se déplacer tout autour de l'objet tridimensionnel codé dans le fichier.

Les modes de réalisation de ce procédé peuvent comporter une ou plusieurs des caractéristiques des revendications dépendantes.

Ces modes de réalisation du procédé de commande présentent en outre les avantages suivants :
- la détermination automatique du coefficient d'échelle permet d'éviter une intervention manuelle de l'utilisateur lorsqu'un fichier numérique est remplacé par un autre fichier numérique contenant, par exemple, le même objet tridimensionnel, mais à une échelle différente ;
- placer le centre géométrique de l'objet tridimensionnel sur le centre géométrique de la zone de mesure permet d'utiliser un coefficient Cₑ plus proches de un et donc de limiter les dégradations de la résolution de l'image en deux dimensions construite causées par un coefficient d'échelle très grand ou très petit ;
- choisir systématiquement le coefficient C_{R} égal à un rend le procédé plus rapide car il n'est pas nécessaire de réitérer à chaque déplacement de l'aimant permanent l'étape de mise en correspondance des dimensions de l'objet tridimensionnel avec les coordonnées mesurées de l'aimant permanent ;
- le déclenchement d'une animation uniquement pour certaines coordonnées ou directions calculées augmente l'interactivité du procédé.

L'invention a également pour objet un support d'enregistrement d'informations comportant des instructions pour l'exécution du procédé de commande ci-dessus lorsque ces instructions sont exécutées par un calculateur électronique.

L'invention a également pour objet un appareil de commande d'une interface graphique conforme à la revendication 8.

Les modes de réalisation de cet appareil peuvent comporter la caractéristique de la revendication dépendante.

L'invention sera mieux comprise à la lecture de la description qui va suivre, donnée uniquement à titre d'exemple non limitatif, et faite en se référant aux dessins sur lesquels :
- la figure 1 est une illustration schématique d'un appareil de commande d'une interface graphique,
- la figure 2 est une illustration schématique partielle et en vue de dessus d'une matrice de magnétomètres utilisée dans l'appareil de la figure 1 ; et
- la figure 3 est un organigramme d'un procédé de commande d'une interface graphique à l'aide de l'appareil de la figure 1.

Dans ces figures, les mêmes références sont utilisées pour désigner les mêmes éléments.

Dans la suite de cette description, les caractéristiques et fonctions bien connues de l'homme du métier ne sont pas décrites en détails.

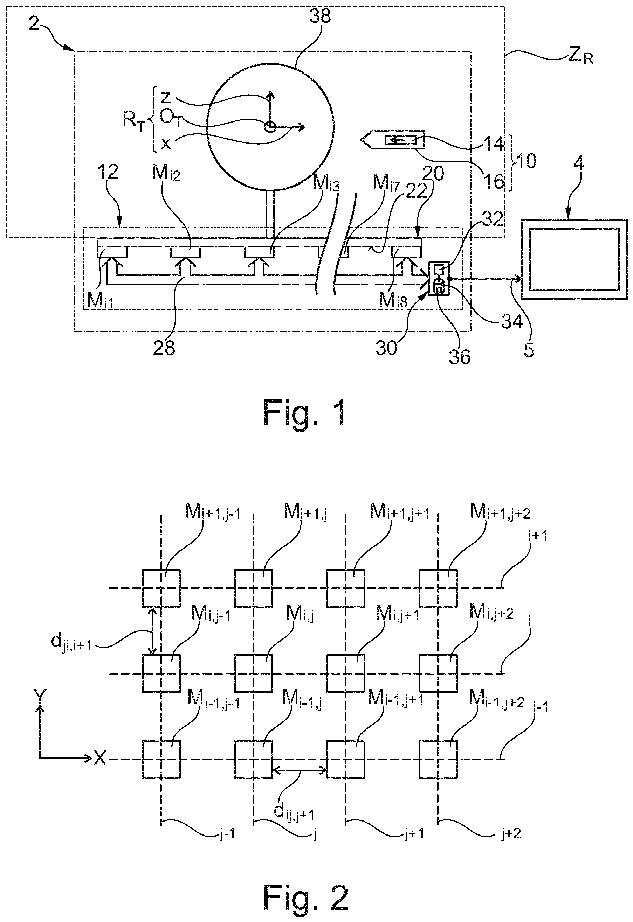

La figure 1 représente un appareil 2 de commande d'une interface graphique 4 pour observer un objet tridimensionnel. Ici, l'interface graphique est un écran raccordé à l'appareil 2 par une liaison filaire 5.

A titre d'illustration, l'objet tridimensionnel est le globe terrestre. L'appareil 2 est utilisé pour sélectionner la région du globe terrestre que l'on souhaite voir apparaître sur l'écran 4 ainsi que l'agrandissement souhaité. Toutefois, l'appareil 2 est adaptable à de nombreuses autres applications comme cela est décrit à la fin de cette description.

L'appareil 2 comporte un pointeur 10 et un dispositif 12 de localisation de ce pointeur 10. Le pointeur 10 permet à l'utilisateur d'indiquer le point de vue et la direction dans laquelle il souhaite regarder le globe terrestre. Ici, le pointeur 10 est librement déplaçable dans un repère orthogonal R_{T} de travail. Ce repère R_{T} est fixé sans aucun degré de liberté au dispositif 12. Les axes X et Y de ce repère R_{T} sont horizontaux et l'axe Z est vertical. L'origine du repère RT est notée O_{T}.

Pour être localisé par le dispositif 12, le pointeur 10 comprend au moins un objet magnétique 14. L'objet 14 est un aimant permanent présentant un moment magnétique non nul même en absence de champ magnétique extérieur. Par exemple, le champ magnétique coercitif de cet aimant est supérieur à 100 A.m⁻¹ ou 500 A.m⁻¹. Typiquement, il est réalisé en matériau ferro- ou ferrimagnétique.

L'objet 14 a une forme oblongue. Sur la figure 1, la direction du moment magnétique de l'objet 14 est représentée par une flèche. La plus grande longueur de cet objet est notée L par la suite. La puissance de l'aimant permanent est typiquement supérieure à 0,01 A.m² ou 0,1 A.m².

Dans ce mode de réalisation, le pointeur 10 comprend également un ustensile 16 non magnétique sur lequel ou à l'intérieur duquel l'objet 14 est fixé sans aucun degré de liberté. Par non magnétique, on entend un ustensile réalisé dans un matériau ne présentant aucune propriété magnétique mesurable. Typiquement, l'ustensile 16 ne présente donc aucune propriété magnétique ou des propriétés magnétiques négligeables par rapport à l'aimant que l'on cherche à repérer.

Par exemple, l'ustensile 16 est un crayon en bois ou en plastique comportant une pointe dans la direction du moment magnétique de l'objet 14. L'ustensile 16 permet aussi de faciliter la manipulation de l'objet 14 si celui-ci est petit. Ici, le pointeur 10 est librement déplaçable à l'intérieur d'une zone Z_{R} tridimensionnel de mesure directement par la main d'un être humain. A cet effet, le pointeur 10 pèse moins d'un kilo et, de préférence, moins de 200g. Les dimensions de ce pointeur sont suffisamment réduites pour qu'il puisse être saisi et déplacé par une seule main d'un utilisateur.

Le dispositif 12 permet de localiser l'objet 14 dans le repère R_{T} et donc de localiser le pointeur 10. Par localisation, on entend ici la détermination de la position x, y, z de l'objet 14 dans le repère R_{T} et aussi la détermination de l'orientation de l'objet 14 par rapport aux axes X, Y et Z du repère R_{T}. Par exemple, l'orientation de l'objet 14 est représentée par les angles θₓ, θ_{y} et θ_{z} du moment magnétique de l'objet 14, respectivement, par rapport aux axes X, Y et Z. Dans ce mode de réalisation, l'origine O_{T} du repère R_{T} est située sur le centre géométrique de la zone Z_{R}. Le centre géométrique d'une zone ou d'un objet est le barycentre de cette zone ou de cet objet obtenu en affectant à chaque point de la zone ou de l'objet le même poids.

Le dispositif 12 comporte un réseau de N magnétomètres tri-axes Mᵢⱼ. Sur la figure 1, les traits ondulés verticaux indiquent qu'une partie du dispositif 12 n'a pas été représentée.

Typiquement, N est supérieur à cinq et, de préférence, supérieur à seize ou trente-deux. Ici, N est supérieur ou égal à soixante-quatre.

Dans ce mode de réalisation, les magnétomètres Mᵢⱼ sont alignés en lignes et en colonnes pour former une matrice. Ici, cette matrice comporte huit lignes et huit colonnes. Les indices i et j identifient, respectivement, la ligne et la colonne de cette matrice à l'intersection de laquelle se trouve le magnétomètre Mᵢⱼ. Sur la figure 1, seuls les magnétomètres Mᵢ₁, Mᵢ₂, Mᵢ₃, Mᵢ₄ et Mᵢ₈ d'une ligne i sont visibles. La position des magnétomètres Mᵢⱼ les uns par rapport aux autres est décrite plus en détail en référence à la figure 2.

Chaque magnétomètre Mᵢⱼ est fixé sans aucun degré de liberté aux autres magnétomètres. A cet effet, les magnétomètres Mᵢⱼ sont fixés sans aucun degré de liberté sur une face arrière 22 d'une plaque rigide 20. Cette plaque rigide présente une face avant tournée vers l'objet 14. La plaque 20 est réalisée dans un matériau non magnétique rigide. Par exemple, la plaque 20 est en verre.

Chaque magnétomètre Mᵢⱼ mesure la direction et l'intensité du champ magnétique généré par l'objet 14. Pour cela, chaque magnétomètre Mᵢⱼ mesure la norme de la projection orthogonale du champ magnétique généré par l'objet 14 au niveau de ce magnétomètre Mᵢⱼ sur trois axes de mesure de ce magnétomètre. Ainsi, chaque magnétomètre Mᵢⱼ mesure un vecteur bᵢⱼ dont chaque coordonnée représente la valeur du champ magnétique projeté sur un axe de mesure respectif. Ici, ces trois axes de mesure sont orthogonaux entre eux. Par exemple, les axes de mesure de chacun des magnétomètres Mᵢⱼ sont, respectivement, parallèles aux axes X, Y et Z du repère R_{T}.

La sensibilité des magnétomètres Mᵢⱼ est fixée. Ici, la sensibilité du magnétomètre Mᵢⱼ est de 4*10⁻⁷T. Ainsi, si l'objet 14 est trop éloigné de ces magnétomètres, le signal mesuré ne peut plus être distingué du bruit. Les dimensions de la zone Z_{R} de mesure sont définies de manière à ce que, quelle que soit la position de l'objet 14 à l'intérieur de cette zone Z_{R}, l'objet 14 est localisé par le dispositif 12 avec une précision inférieure à un seuil Sₚ prédéterminé. Comme illustré sur la figure 1, cette zone Z_{R} peut alors s'étendre au-delà des dimensions latérales de la matrice de magnétomètres. Par exemple, si la matrice de magnétomètres forme un carré dont la longueur du côté est B, la zone Z_{R} peut contenir une bande de largeur B/2 tout autour de cette matrice. Les dimensions de la zone Z_{R} sont déterminées expérimentalement ou par calcul à partir de la sensibilité des magnétomètres Mᵢⱼ.

Chaque magnétomètre Mᵢⱼ est raccordé par l'intermédiaire d'un bus 28 de transmission d'informations à une unité de traitement 30.

L'unité de traitement 30 est notamment capable de traiter les mesures des magnétomètres Mᵢⱼ, et de commander l'écran 4 en fonction de ces mesures.

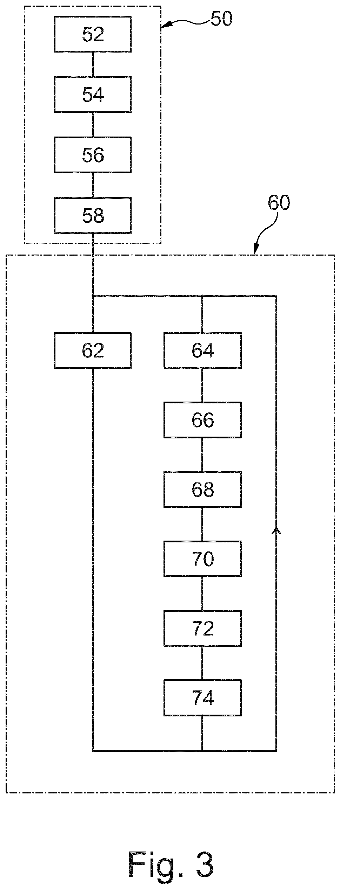

A cet effet, l'unité 30 comporte un calculateur électronique 32 programmable apte à exécuter des instructions enregistrées sur un support d'enregistrement d'informations. L'unité 30 comporte donc aussi une mémoire 34 contenant les instructions nécessaires pour l'exécution par le calculateur 32 du procédé de la figure 3. La mémoire 34 comporte aussi un fichier numérique 36 codant les dimensions et les détails de l'objet tridimensionnel que l'on souhaite observer sur l'écran 4. Ces dimensions et détails sont repérés, dans ce fichier, par rapport à un repère tridimensionnel virtuel R_{V} dont l'origine est notée O_{V}. Ce repère R_{V} est ici un repère orthogonal. De plus, sa position et son orientation par rapport au repère R_{T} sont connues. Ici, par défaut, l'origine O_{V} et les axes X, Y et Z du repère R_{V} sont confondues, respectivement, avec l'origine O_{T} et les axes X, Y et Z du repère R_{T}. Par exemple, cette relation entre les repères R_{T} et R_{V} est enregistrée dans la mémoire 34. La mémoire 34 contient également les dimensions de la zone Z_{R} de mesure du dispositif 12.

L'unité de traitement 30 est, en particulier, apte à déterminer la position et l'orientation d'un dipôle magnétique dans le repère R_{T} à partir des mesures des magnétomètres Mᵢⱼ. A cet effet, l'unité 30 implémente un modèle mathématique M_{P} associant chaque mesure d'un magnétomètre Mᵢⱼ aux position, orientation et amplitude du moment magnétique d'un dipôle magnétique dans le repère R_{T}. Le modèle M_{P} se présente sous la forme d'un système d'équations dans lequel un premier jeu de variables représente la position et l'orientation du dipôle magnétique ainsi que l'amplitude du moment magnétique de ce dipôle. Un second jeu de variables représente les mesures des magnétomètres Mᵢⱼ. Pour obtenir, la position, l'orientation et l'amplitude du moment magnétique du dipôle magnétique, les variables du premier jeu sont les inconnues et les valeurs des variables du second jeu sont connues. Ce modèle est typiquement construit à partir des équations physiques de l'électromagnétisme. Ce modèle est paramétré par les distances connues entres les magnétomètres Mᵢⱼ. Pour construire ce modèle, l'objet magnétique 14 est approximé par un dipôle magnétique. Cette approximation n'introduit que très peu d'erreurs si la distance entre l'objet 14 et le magnétomètre Mᵢⱼ est supérieure à 2L et, de préférence, supérieure à 3L, où L est la plus grande dimension de l'objet 14. Typiquement, L est inférieur à 20cm et, de préférence, inférieur à 10 ou 5cm.

Ici, le modèle M_{P} est non linéaire. L'unité 30 le résout en mettant en oeuvre un algorithme d'estimation de sa solution. Par exemple, l'algorithme utilisé est un filtre de Kalman d'ensemble plus connu sous le terme anglais de « Unscented Kalman Filter ».

L'unité 30 est également capable de construire une image à afficher sur l'écran 4 à partir des données contenues dans le fichier 36, de la position d'un point de vue, de la direction d'un axe optique et d'un angle de prise de vue donné.

Dans ce mode de réalisation particulier, l'appareil 2 comprend une maquette 38 de l'objet tridimensionnel à observer. Ici la maquette 38 est un modèle réduit du globe terrestre. Cette maquette est fixée sans aucun degré de liberté au-dessus de la tablette 20 de sorte que son centre géométrique soit confondu avec l'origine O_{T} du repère R_{T}. Les dimensions de cette maquette sont telles qu'elle est entièrement contenue à l'intérieur de la zone Z_{R}.

La figure 2 représente une partie des magnétomètres Mᵢⱼ du dispositif 12. Ces magnétomètres Mᵢⱼ sont alignés en lignes i parallèles à la direction X. Ces magnétomètres sont également alignés en colonnes j parallèles à la direction Y pour former une matrice. Les lignes i et les colonnes j sont disposées dans l'ordre des indices croissants.

Le centre du magnétomètre Mᵢⱼ se trouve à l'intersection de la ligne i et de la colonne j. Le centre du magnétomètre correspond au point où le champ magnétique est mesuré par ce magnétomètre. Ici, les indices i et j appartiennent à l'intervalle [1 ; 8].

Les centres de deux magnétomètres Mᵢⱼ et M_{i,j+1} immédiatement consécutifs le long d'une ligne i sont séparés par une distance connue d_{i,j},ⱼ₊₁. De façon similaire, le centre de deux magnétomètres Mᵢⱼ et M_{i+1,j} immédiatement consécutifs le long d'une même colonne j sont séparés par une distance connue d_{j,i},ᵢ₊₁.

Dans le cas particulier décrit ici, quelle que soit la ligne i, la distance d_{i,j},ⱼ₊₁ est la même. Cette distance est donc notée dⱼ. De façon similaire, quelle que soit la colonne j, la distance d_{j,i},ᵢ₊₁ entre deux magnétomètres est la même. Cette distance est donc notée dᵢ.

Ici, les distances dᵢ et dⱼ sont toutes les deux égales à d.

Typiquement, la distance d est comprise entre 1 et 4 cm lorsque :
- la puissance de l'aimant permanent est de 0,5 A.m²,
- la sensibilité des magnétomètres est de 4*10⁻⁷T, et
- le nombre de magnétomètres Mᵢⱼ est de soixante-quatre.

Le fonctionnement de l'appareil 2 va maintenant être décrit en référence au procédé de la figure 3.

Le procédé débute par une phase 50 d'initialisation. Au début de cette phase, l'appareil 2 permettant de commander l'écran 4 est fourni puis raccordé à cet écran.

Ensuite, lors d'une étape 52, les dimensions de la zone de mesure Z_{R}, les dimensions de la maquette 38 et le fichier 36 sont enregistrés dans la mémoire 34. Par exemple, la zone Z_{R} est une demi-sphère de diamètre 2B située au-dessus de la table 20 et dont la partie plane, et située dans le plan contenant les magnétomètres Mᵢⱼ. Cette demi-sphère est centrée sur la matrice de magnétomètres.

La maquette 38 est ici une sphère de diamètre D_{M} dont le centre est confondu avec l'origine O_{T}. Enfin, on suppose également ici que les dimensions de l'objet tridimensionnel codé dans le fichier 36 sont à l'échelle un. Étant donné que l'objet tridimensionnel est le globe terrestre, ses dimensions sont exprimées en kilomètres ou en mètres dans le fichier 36.

Ensuite, lors d'une étape 54, si le centre géométrique de l'objet tridimensionnel codé dans le fichier 36 n'est pas confondu avec l'origine O_{V} du repère R_{V}, alors l'unité 30 translate l'objet tridimensionnel dans le repère R_{V} de manière à ce que son centre géométrique soit confondu avec l'origine O_{V} de ce repère. Le nouveau fichier numérique contenant l'objet tridimensionnel translaté est ensuite enregistré à la place du précédent fichier numérique 36.

Lors d'une étape 56, l'unité 30 détermine automatiquement un coefficient d'échelle Cₑ à partir des dimensions de l'objet tridimensionnel codées dans le fichier numérique 36 et des dimensions connues de la zone Z_{R}. Ce coefficient Cₑ est ensuite utilisé pour multiplier les dimensions de l'objet tridimensionnel par ce coefficient Cₑ de manière à obtenir un objet tridimensionnel mis à l'échelle. Ici, ce coefficient Cₑ est choisi de manière à ce que l'objet tridimensionnel mis à l'échelle soit entièrement situé à l'intérieur de la zone Z_{R}. Pour cela, ce coefficient Cₑ est choisi inférieur au ratio d_{Z}/dₘₐₓ, où :
- dₘₐₓ est la distance entre l'origine O_{T} et le point de l'objet tridimensionnel le plus éloigné de cette origine O_{T} le long d'un axe de mesure, et
- d_{Z} est la distance entre l'origine O_{T} et le point de la zone de mesure le plus éloigné de cette origine le long du même axe de mesure, et
- l'axe de mesure retenu est un axe passant par l'origine O_{T} et qui maximise l'écart | dₘₐₓ - d_{Z} | , où | ... | est la fonction valeur absolue.

Ainsi, par exemple, l'unité 30 calcule d'abord le rapport d_{Z}/dₘₐₓ à partir des informations enregistrées dans la mémoire 34 lors de l'étape 52. Dans le cas particulier décrit ici, l'axe de mesure qui maximise l'écart | dₘₐₓ - d_{Z} | est l'axe Z. La distance dₘₐₓ est égale au rayon du globe terrestre enregistré dans le fichier numérique 36.

Ensuite, la valeur du coefficient Cₑ est choisie égale à a*(d_{Z}/dₘₐₓ), où « a » est une constante préenregistrée inférieure ou égale à un. De préférence, la constante « a » est supérieures à 0,1 ou à 0,5.

Dans ce mode de réalisation particulier, le coefficient Cₑ est en plus déterminé pour que l'objet tridimensionnel mis à l'échelle soit confondu avec la maquette 38 dans le repère R_{T}. A cette fin, la constante « a » est choisie égale à (D_{M}dₘₐₓ)/(D_{V}d_{Z}), où Dv est le diamètre du globe terrestre codé dans le fichier numérique 36. Dans le cas particulier, où les dimensions de la maquette sont connues, il est aussi possible de calculer directement la valeur du coefficient Cₑ sans passer par le calcul du rapport d_{Z}/dₘₐₓ. Par exemple, ici, la valeur du coefficient Cₑ est égale à D_{M}/D_{V}.

Lors d'une opération 58, l'unité 30 détermine les dimensions du champ de prise de vue. Ici, le champ de prise de vue est défini par deux angles θ_{H} et θ_{V} de prise de vue. Les angles θ_{H} et θ_{V} sont les angles de prise de vue dans les plans, respectivement, horizontal et vertical. Pour simplifier la description, ces angles sont tous les deux pris égaux à des constantes préenregistrées.

Enfin, l'orientation du champ de prise de vue est choisie constante. Ici, on suppose que la verticale de l'image est toujours confondue avec la direction Z du repère R_{T}.

Une fois la phase d'initialisation 50 terminée, l'unité 30 procède à une phase 60 d'utilisation de l'appareil 2 pour commander l'affichage d'images du globe terrestre sur l'écran 4.

A cet effet, lors d'une étape 62, un utilisateur saisit le pointeur 10 et le manipule à l'intérieur de la zone Z_{R} comme s'il s'agissait d'une caméra lui permettant de filmer la surface de la maquette 38. Pour cela, il place le pointeur 10 à l'emplacement du point de vue qu'il souhaite utiliser et dirige la pointe de l'ustensile 16 le long de l'axe optique qu'il souhaite utiliser.

En parallèle de l'étape 62, lors d'une étape 64, les magnétomètres Mᵢⱼ mesurent le champ magnétique généré par l'objet 14.

Puis, lors d'une étape 66, ces mesures sont acquises par l'unité 30 de traitement.

Lors d'une étape 68, l'unité 30 calcule alors les coordonnées de l'objet 14 dans le repère R_{T} à partir des mesures acquises lors de l'étape 66. L'unité 30 calcule également à partir de ces mesures, la direction et l'amplitude du moment magnétique de l'objet 14 dans le repère R_{T}.

Lors d'une étape 70, l'unité 30 met en correspondance les dimensions de l'objet tridimensionnel par rapport aux coordonnées calculées lors de l'étape 68. Ici, si cela n'a pas déjà été fait, cela consiste à multiplier toutes les dimensions de l'objet tridimensionnel codé dans le fichier numérique 36 par le coefficient Cₑ de manière à obtenir un objet tridimensionnel mis à l'échelle. Les dimensions de cet objet tridimensionnel mis à l'échelle sont exprimées dans le repère R_{T}. Elles sont mémorisées dans la mémoire 34 afin de ne pas avoir à refaire ces multiplications lors de la prochaine itération de l'étape 70.

Lors d'une étape 72, l'unité 30 construit une image en deux dimensions de l'objet tridimensionnel mis à l'échelle qui correspond à l'image qui serait obtenue si cet objet tridimensionnel était filmé depuis :
- un point de vue égal à la position calculée de l'objet 14 lors de l'étape 68,
- selon un axe optique confondu avec la direction du moment magnétique calculée lors de l'étape 68,
- dans la direction du moment magnétique calculée lors de l'étape 68,
- avec les angles de prise de vue θ_{H} et θ_{V} fixés pendant la phase 50 d'initialisation, et
- avec la direction verticale de l'image construite confondue avec l'axe Z du repère R_{T}.

Par exemple, l'image en deux dimensions est construite par l'unité 30 à l'aide d'une projection orthogonale de l'objet tridimensionnel mis à l'échelle sur un plan perpendiculaire à l'axe optique et en conservant uniquement les points de cet objet tridimensionnel mis à l'échelle compris dans le champ de la caméra défini par les angles θ_{V} et θ_{H}.

La construction d'une telle image en deux dimensions à partir d'un objet tridimensionnel est bien connue. On pourra par exemple se référer à ce sujet aux algorithmes utilisés dans les logiciels de conception assistée par ordinateur (CAO).

Ensuite, lors d'une étape 74, l'unité 30 commande l'affichage de l'image construite lors de l'étape 72 sur l'écran 4.

Les étapes 64 à 74 sont réitérées à chaque fois que le pointeur 10 est déplacé.

Ainsi, avec l'appareil 2, en manipulant le pointeur 10 comme une caméra, l'utilisateur peut facilement et très intuitivement indiquer à la fois la position du point de vue et la direction de l'axe optique à utiliser pour construire une image en deux dimensions de l'objet tridimensionnel codé dans le fichier numérique 36. En particulier, l'utilisateur retrouve le comportement ordinaire d'une caméra comme, par exemple :
- l'agrandissement de la région filmée par la caméra lorsque le pointeur 10 se rapproche de la surface de la maquette 38,
- le déplacement de l'image construite en deux dimensions vers la droite quand le pointeur 10 est tourné vers la droite et inversement, et
- le déplacement de la position du point de vue quand la position du pointeur 10 est déplacée.

De nombreux autres modes de réalisation sont possibles. Par exemple, il est possible de fixer la direction de l'axe optique de sorte que cette direction est indépendante des déplacements du pointeur 10. Dès lors, le déplacement du pointeur 10 est uniquement utilisé pour indiquer quelle est la position du point de vue. A l'inverse, il est également possible de fixer la position du point de vue de sorte que cette position est indépendante de la position du pointeur 10. Dans ce dernier mode de réalisation, le pointeur 10 est alors uniquement utilisé pour indiquer quelle est la direction de l'axe optique à utiliser.

Dans d'autres modes de réalisation, le déplacement de l'objet 14 à l'intérieur de la zone Z_{R} de mesure n'est pas entièrement libre mais guidé de manière à limiter le nombre de degré de liberté du pointeur 10. Par exemple, le pointeur 10 est monté à coulissement sur un rail de sorte qu'il ne peut se déplacer à l'intérieur de la zone Z_{R} qu'en suivant ce rail.

Dans le mode de réalisation précédent, l'appareil 2 a été décrit dans le cas particulier où la relation entre la position mesurée du pointeur 10 et la position du point de vue dans le repère R_{T} est une relation d'identité. Toutefois, en variante, cette relation peut être remplacée par n'importe quelle relation bijective. Par exemple, la relation entre la position du pointeur 10 et la position du point de vue est une relation non linéaire, telle qu'une relation exponentielle. Dès lors, un déplacement du pointeur 10 à proximité de la surface de la maquette 38 et le même déplacement mais loin de cette surface, ne modifie pas de la même façon la position du point de vue. Il est aussi possible de relier l'orientation de l'axe optique à la direction du moment magnétique de l'objet 14 par une autre fonction bijective que l'identité.

La mise en correspondance des dimensions de l'objet tridimensionnel et des coordonnées mesurées du pointeur 10 peut aussi être réalisée en laissant les dimensions de l'objet tridimensionnel inchangées et en multipliant les coordonnées mesurées du pointeur 10 par l'inverse du coefficient Cₑ. Cette multiplication doit alors être réalisée à chaque itération de l'étape 70. De façon plus générale, il est possible de multiplier les dimensions de l'objet tridimensionnel par un coefficient C_{V} et, en même temps, de diviser les coordonnées du pointeur 10 par un coefficient C_{R}. Dans ce cas, ces coefficients C_{V} et C_{R} sont choisis tels que la relation suivante soit vérifiée : C_{V}/C_{R} = Ce.

Dans un mode de réalisation simplifié, le coefficient Cₑ n'est pas déterminé automatiquement mais fixé par l'utilisateur, par exemple, lors de la phase d'initialisation.

En variante, le pointeur 10 comporte deux aimants permanents dont les directions des moments magnétiques font un angle compris entre 10° et 170° dans le plan contenant ces deux directions. L'appareil 12 est alors adapté pour localiser ces aimants permanents. Pour cela, le modèle M_{P} est établi en modélisant les interactions magnétiques entre les magnétomètres Mᵢⱼ et deux dipôles magnétiques simultanément présents dans la zone de mesure. Le fait que les directions des moments magnétiques des deux aimants permanents ne soient pas colinéaires, permet à l'appareil 12 de déterminer l'angle de roulis du pointeur 10 autour de sa direction longitudinale. Cet angle de roulis est ensuite utilisé, par exemple, pour commander une rotation de l'image construite autour de l'axe optique. Dans ce mode de réalisation, la direction verticale de l'image construite n'est pas fixée à l'avance mais déterminée à partir de la position des aimants permanents.

L'objet tridimensionnel peut être n'importe quel type d'objet. Par exemple, il peut s'agir d'une ville ou d'un quartier, comportant des rues et des immeubles en trois dimensions. Le procédé décrit précédemment permet alors à l'utilisateur d'obtenir de façon très intuitive le point de vue et l'axe optique à partir duquel la ville ou le quartier est observé. Il peut aussi s'agir de l'intérieur d'un édifice tel qu'un musée ou un appartement. L'objet tridimensionnel ne correspond pas nécessairement à un objet existant dans le monde réel. Par exemple, il peut s'agir d'un monde imaginaire créé pour un jeu vidéo.

De plus, l'objet tridimensionnel peut comporter des parties animées. Par exemple, dans le cas où l'objet tridimensionnel est une maquette d'une ville, le fichier numérique peut en plus coder le déplacement de piétons ou de véhicules dans les rues de cette ville.

En variante, l'unité de traitement 30 est programmée pour déclencher l'exécution d'une animation directement perceptible par un être humain en fonction de la position et de l'orientation mesurées du pointeur 10. Typiquement, l'animation est une animation graphique visible sur un écran ou une animation audio directement audible par un être humain lorsqu'elle est jouée par un haut-parleur. L'animation graphique est, de préférence, incorporée à l'image construite de façon à être affichée sur le même écran que celui où est affichée l'image construite. Cela permet de rendre l'appareil 2 plus interactif. Par exemple, lorsque le pointeur 10 est dirigé vers une région particulière de l'objet tridimensionnel, cela déclenche le jeu d'une bande sonore directement audible par l'utilisateur. Par exemple, la bande sonore jouée comporte un commentaire spécifique à cette région particulière. On peut aussi programmer l'unité de traitement 30 pour déclencher, en réponse à une plage de positions et/ou d'orientations du pointeur 10, une animation graphique directement visible sur l'écran 4. Dans ce dernier cas, cela permet de limiter la puissance de calcul nécessaire car les animations graphiques qui ne sont pas visibles, ne sont pas exécutées. On a ainsi la possibilité de réaliser un jeu de cette manière

Les dimensions de l'objet tridimensionnel codées dans le fichier numérique ne sont pas nécessairement supérieures aux dimensions de la zone Z_{R}. A l'inverse, le fichier numérique peut coder des dimensions d'un objet tridimensionnel beaucoup plus petit que les dimensions de la zone Z_{R}. Par exemple, l'objet tridimensionnel peut être un atome ou une molécule. Dans ce cas, le coefficient Cₑ est beaucoup plus grand que un.

L'étape 70 de mise en correspondance peut aussi être réalisée lors de la phase d'initialisation lorsque seules les dimensions de l'objet tridimensionnel sont multipliées par le coefficient Cₑ.

Dans le mode de réalisation précédent, l'interface graphique a été décrite dans le cas particulier où celle-ci est un écran 4. Toutefois, l'interface graphique peut être tout type d'interface permettant d'afficher une image, tel que par exemple l'écran d'un téléviseur ou d'un ordinateur ou encore un projecteur ou un rétroprojecteur.

Dans un mode de réalisation simplifié, la maquette 38 est omise. Dans ce cas, l'utilisateur s'oriente dans la zone de mesure en utilisant pour cela les images en deux dimensions affichées sur l'écran 4.

De nombreuses méthodes différentes sont utilisables pour déterminer la position et l'orientation de l'aimant permanent. Par exemple, la méthode décrite dans US6269324 est utilisable. Ces méthodes n'utilisent pas nécessairement un filtre de Kalman. Par exemple, les méthodes décrites dans US2002/171427A1 ou US6263230B1 sont possibles.

Les magnétomètres du réseau de magnétomètres ne sont pas nécessairement rangés en colonnes et en lignes. Ils peuvent être agencés aussi selon d'autres motifs. Par exemple, les magnétomètres sont disposés sur chaque sommet de chaque maille triangulaire ou hexagonale d'un maillage d'un plan.

La disposition des magnétomètres les uns par rapport aux autres peut aussi être aléatoire ou non régulière. Ainsi, la distance entre deux magnétomètres immédiatement consécutifs dans le réseau n'est pas nécessairement la même pour toutes les paires de deux magnétomètres immédiatement consécutifs. Par exemple, la densité de magnétomètres dans une zone donnée du réseau peut être plus importante qu'ailleurs. Augmenter la densité dans une zone donnée peut permettre d'augmenter la précision de la mesure dans cette zone.

Le réseau de magnétomètres peut aussi s'étendre dans trois directions non colinéaires de l'espace. Dans ces conditions, les magnétomètres sont répartis à l'intérieur d'un volume à trois dimensions.

Le nombre N de magnétomètres peut également être supérieur ou égal à soixante-quatre ou quatre-vingt dix.

Tous les magnétomètres du réseau de magnétomètres ne sont pas nécessairement identiques les uns aux autres. En variante, les magnétomètres n'ont pas tous la même sensibilité. Dans ce cas, les magnétomètres moins précis sont par exemple disposés à proximité du centre du réseau tandis que les magnétomètres les plus précis sont disposés sur la périphérie de ce réseau. Un tel mode de réalisation présente l'avantage de placer les magnétomètres les plus difficilement saturables et donc les moins sensibles, aux emplacements susceptibles d'être le plus proche de l'objet magnétique. Cela permet aussi d'étendre la zone d'interaction.

## Revendications

1. Procédé de commande d'une interface graphique pour afficher des images d'un objet tridimensionnel, **caractérisé en ce que** ce procédé comporte :
- la fourniture d'un réseau de magnétomètres comportant N magnétomètres triaxes (Mᵢⱼ) reliés mécaniquement les uns aux autres sans aucun degré de liberté pour conserver une distance connue entre chacun de ces magnétomètres, où N est un nombre entier supérieur ou égal à cinq, ce réseau de magnétomètres étant associé :
• à un repère tridimensionnel de travail dont la position est connue par rapport au réseau de magnétomètres, et
• à une zone de mesure tridimensionnelle prédéterminée,
- l'enregistrement (52) d'un fichier numérique codant les dimensions de l'objet tridimensionnel dans un repère tridimensionnel dit « virtuel », la position de ce repère virtuel par rapport au repère de travail étant connue de sorte que les coordonnées de chaque point du repère virtuel peuvent être exprimées dans le repère de travail par un changement de repère,
- la fourniture d'un pointeur comportant un aimant permanent déplaçable manuellement par un utilisateur à l'intérieur de la zone de mesure,
- lorsque l'aimant permanent est placé à l'intérieur de la zone de mesure, la mesure (64), par les magnétomètres du réseau, du champ magnétique généré par l'aimant permanent,
- le calcul (68) des coordonnées de l'aimant permanent et de la direction du moment magnétique de l'aimant permanent dans le repère de travail à partir des mesures des magnétomètres,
- la mise en correspondance (70) des dimensions de l'objet tridimensionnel avec les coordonnées précédemment calculées en multipliant chaque dimension de l'objet tridimensionnel par un coefficient C_{V} pour obtenir un objet tridimensionnel mis à l'échelle et en multipliant les coordonnées calculées par l'inverse d'un coefficient C_{R} pour obtenir des coordonnées à l'échelle, où les coefficients Cᵥ et C_{R} sont choisis tels que le rapport C_{V}/C_{R} est égal à un coefficient Cₑ d'échelle, ce coefficient Cₑ étant strictement inférieur à d_{Z}/dₘₐₓ, où :
• dₘₐₓ est la distance entre l'origine du repère de travail et le point de l'objet tridimensionnel le plus éloigné de cette origine le long d'un axe de mesure, et
• d_{Z} est la distance entre l'origine du repère de travail et le point de la zone de mesure le plus éloigné de cette origine le long du même axe de mesure,
• l'axe de mesure retenu étant l'axe passant par l'origine du repère de travail et pour lequel l'écart | dₘₐₓ - d_{Z} | est maximum,
- la construction (72) d'une image en deux dimensions correspondant à l'image de l'objet mis à l'échelle observé depuis un point de vue et le long d'un axe optique prédéterminé,
• la position du point de vue étant déduite des coordonnées à l'échelle, et
• la direction de l'axe optique étant déduite de la direction mesurée du moment magnétique de l'aimant permanent, et
- la commande (74) de l'interface graphique pour afficher l'image construite sur cette interface graphique.

2. Procédé selon la revendication 1, dans lequel le procédé comprend la détermination (56) automatique du coefficient Cₑ d'échelle en calculant automatiquement le rapport d_{Z}/dₘₐₓ à partir des dimensions de l'objet tridimensionnel codées dans le fichier numérique et des dimensions connues de la zone de mesure, puis en prenant la valeur du coefficient Cₑ égale à a*(d_{Z}/dₘₐₓ), où « a » est une constante préenregistrée.

3. Procédé selon la revendication 1, dans lequel le procédé comprend la détermination (56) automatique du coefficient Cₑ d'échelle à partir d'un rapport entre une dimension de l'objet tridimensionnel codée dans le fichier numérique et d'une dimension connue d'une maquette de cet objet contenue à l'intérieur de la zone de mesure.

4. Procédé selon la revendication 2 ou 3, dans lequel, avant la détermination automatique du coefficient Cₑ d'échelle, le procédé comprend la translation (54) des coordonnées de chaque point de l'objet tridimensionnel dans le repère virtuel pour que le centre géométrique de l'objet tridimensionnel translaté soit confondu avec le centre géométrique de la zone de mesure et la détermination du coefficient Cₑ est réalisée à partir des dimensions de l'objet tridimensionnel ainsi translaté.

5. Procédé selon l'une quelconque des revendications précédentes, dans lequel le coefficient C_{R} est systématiquement pris égal à un de sorte que seules les dimensions de l'objet tridimensionnel sont mises à l'échelle.

6. Procédé selon l'une quelconque des revendications précédentes, dans lequel, en fonction des coordonnées calculées ou de la direction calculée de l'aimant permanent, une animation directement perceptible par un être humain est exécutée en même temps que l'interface graphique est commandée pour afficher l'image construite correspondant à ces coordonnées calculées ou à cette direction calculée.

7. Support (34) d'enregistrement d'informations, **caractérisé en ce qu'**il comporte des instructions pour l'exécution d'un procédé conforme à l'une quelconque des revendications précédentes, lorsque ces instructions sont exécutées par un calculateur électronique.

8. Appareil de commande d'une interface graphique pour afficher des images d'un objet tridimensionnel, cet appareil comportant :
- un réseau de magnétomètres comportant N magnétomètres tri-axes (Mᵢⱼ) reliés mécaniquement les uns aux autres sans aucun degré de liberté pour conserver une distance connue entre chacun de ces magnétomètres, où N est un nombre entier supérieur ou égal à cinq, ce réseau de magnétomètres étant associé :
• à un repère tridimensionnel de travail dont la position est connue par rapport au réseau de magnétomètres, et
• à une zone de mesure tridimensionnelle prédéterminée,
- un fichier numérique (36) codant les dimensions de l'objet tridimensionnel dans un repère tridimensionnel dit « virtuel », la position de ce repère virtuel par rapport au repère de travail étant connue de sorte que les coordonnées de chaque point du repère virtuel peuvent être exprimées dans le repère de travail par un changement de repère et vice-versa,
- un pointeur (10) comportant un aimant permanent (14) déplaçable manuellement par un utilisateur à l'intérieur de la zone de mesure,
- une unité (30) de traitement programmée pour :
• lorsque l'aimant permanent est placé à l'intérieur de la zone de mesure, acquérir la mesure, réalisée par les magnétomètres du réseau, du champ magnétique généré par l'aimant permanent,
• calculer des coordonnées de l'aimant permanent et la direction du moment magnétique de l'aimant permanent dans le repère de travail à partir des mesures des magnétomètres,
• mettre en correspondance des dimensions de l'objet tridimensionnel avec les coordonnées précédemment calculées en multipliant chaque dimension de l'objet tridimensionnel par un coefficient Cv pour obtenir un objet tridimensionnel mis à l'échelle et en multipliant les coordonnées calculées par l'inverse d'un coefficient C_{R} pour obtenir des coordonnées à l'échelle, où les coefficients Cᵥ et C_{R} sont choisis tels que le rapport C_{V}/C_{R} est égal à un coefficient Cₑ d'échelle, ce coefficient Cₑ étant strictement inférieur à d_{Z}/dₘₐₓ, où :
- dₘₐₓ est la distance entre l'origine du repère de travail et le point de l'objet tridimensionnel le plus éloigné de cette origine le long d'un axe de mesure, et
- d_{Z} est la distance entre l'origine du repère de travail et le point de la zone de mesure le plus éloigné de cette origine le long du même axe de mesure,
- l'axe de mesure retenu étant l'axe passant par l'origine du repère de travail et pour lequel l'écart | dₘₐₓ - d_{Z} | est maximum,
• construire une image en deux dimensions correspondant à l'image de l'objet mis à l'échelle observé depuis un point de vue et le long d'un axe optique prédéterminé,
- la position du point de vue étant déduite des coordonnées à l'échelle, et
- la direction de l'axe optique étant déduite de la direction mesurée du moment magnétique de l'aimant permanent, et
• commander l'interface graphique pour afficher l'image construite de l'objet tridimensionnel sur cette interface graphique.

9. Appareil selon la revendication 8, dans lequel, l'appareil comporte une maquette (38) réelle de l'objet tridimensionnel dont les dimensions sont égales aux dimensions de l'objet tridimensionnel mis à l'échelle, cette maquette étant placée dans le repère de travail au même emplacement que l'objet tridimensionnel mis à l'échelle.

## Patentansprüche

1. Verfahren zur Steuerung einer grafischen Schnittstelle zur Anzeige von Bildern eines dreidimensionalen Objekts, **dadurch gekennzeichnet, dass** dieses Verfahren Folgendes umfasst:
- Bereitstellen eines Netzwerks von Magnetometern, umfassend N triaxiale Magnetometer (Mᵢⱼ), die ohne jeglichen Freiheitsgrad mechanisch miteinander verbunden sind, um einen bekannten Abstand zwischen jedem dieser Magnetometer einzuhalten, wobei N eine ganze Zahl größer oder gleich fünf ist, wobei dieses Netzwerk von Magnetometern zugeordnet ist:
• einem dreidimensionalen Arbeitsbezugssystem, dessen Position gegenüber dem Netzwerk von Magnetometern bekannt ist, und
• einem vorbestimmten dreidimensionalen Messbereich,
- Aufzeichnen (52) einer digitalen Datei, die die Abmessungen des dreidimensionalen Objekts in einem sogenannten "virtuellen" dreidimensionalen Bezugssystem kodiert, wobei die Position des virtuellen Bezugssystems gegenüber dem Arbeitsbezugssystem bekannt ist, so dass die Koordinaten jedes Punkts des virtuellen Bezugssystems im Arbeitsbezugssystem durch einen Wechsel des Bezugssystems ausgedrückt werden können,
- Bereitstellen eines Zeigers mit einem Permanentmagneten, der von einem Benutzer innerhalb des Messbereichs manuell bewegt werden kann,
- Messen (64) des vom Permanentmagneten erzeugten Magnetfelds durch die Magnetometer des Netzwerks, wenn der Permanentmagnet innerhalb des Messbereichs angeordnet ist,
- Berechnen (68) der Koordinaten des Permanentmagneten und der Richtung des magnetischen Moments des Permanentmagneten in dem Arbeitsbezugssystem aus den Messungen der Magnetometer,
- Zuordnen (70) der Abmessungen des dreidimensionalen Objekts zu den Koordinaten, die zuvor berechnet wurden, indem jede Abmessung des dreidimensionalen Objekts mit einem Koeffizienten C_{V} multipliziert wird, um ein skaliertes dreidimensionales Objekt zu erhalten, und indem die Koordinaten multipliziert werden, die mit der Umkehrung eines Koeffizienten C_{R} berechnet wurden, um skalierte Koordinaten zu erhalten, wobei die Koeffizienten C_{V} und C_{R} so gewählt werden, dass das Verhältnis C_{V}/C_{R} gleich einem Koeffizienten Cₑ der Skala ist, wobei dieser Koeffizient Cₑ strikt niedriger als d_{z}/dₘₐₓ ist, wobei:
• dₘₐₓ der Abstand zwischen dem Ursprung des Arbeitsbezugssystems und dem Punkt des dreidimensionalen Objekts ist, der von diesem Ursprung entlang einer Messachse am weitesten entfernt ist, und
• d_{z} der Abstand zwischen dem Ursprung des Arbeitsbezugssystems und dem Punkt des Messbereichs ist, der von diesem Ursprung entlang derselben Messachse am weitesten entfernt ist, und
• die gewählte Messachse die Achse ist, die durch den Ursprung des Arbeitsbezugssystems verläuft und für die die Abweichung | dₘₐₓ - d_{z} | maximal ist,
- Konstruieren (72) eines zweidimensionalen Bildes, das dem Bild des skalierten Objekts entspricht, das aus einem Blickwinkel und entlang einer vorbestimmten optischen Achse betrachtet wird,
• wobei die Position des Blickwinkels aus den Koordinaten der Skala abgeleitet wird, und
• die Richtung der optischen Achse aus der gemessenen Richtung des magnetischen Moments des Permanentmagneten abgeleitet wird, und
- Anweisen (74) der grafischen Benutzeroberfläche, das auf dieser grafischen Benutzeroberfläche konstruierte Bild anzuzeigen.

2. Verfahren nach Anspruch 1, wobei das Verfahren das automatische Bestimmen (56) des Skalenkoeffizienten Cₑ umfasst, indem das Verhältnis d_{z}/dₘₐₓ aus den Abmessungen des dreidimensionalen Objekts, die in der digitalen Datei kodiert sind, und den aus dem Messbereich bekannten Abmessungen automatisch berechnet wird und anschließend der Wert des Koeffizienten Cₑ gleich a*(d_{z}/dₘₐₓ) genommen wird, wobei "a" eine vorregistrierte Konstante ist.

3. Verfahren nach Anspruch 1, wobei das Verfahren das automatische Bestimmen (56) des Skalenkoeffizienten Cₑ aus einem Verhältnis zwischen einer Abmessung des dreidimensionalen Objekts, die in der digitalen Datei kodiert ist, und einer aus einem Modell dieses Objekts bekannten Abmessung, die innerhalb des Messbereichs enthalten ist, umfasst.

4. Verfahren nach Anspruch 2 oder 3, wobei das Verfahren vor dem automatischen Bestimmen des Skalen koeffizienten Cₑ das Verschieben (54) der Koordinaten jedes Punkts des dreidimensionalen Objekts in das virtuelle Bezugssystem, sodass das geometrische Zentrum des verschobenen dreidimensionalen Objekts mit dem geometrischen Zentrum des Messbereichs zusammenfällt, und das Bestimmen des Skalenkoeffizienten Cₑ aus den Abmessungen des so verschobenen dreidimensionalen Objekts umfasst.

5. Verfahren nach einem der vorgenannten Ansprüche, wobei der Koeffizient C_{R} systematisch gleich eins genommen wird, sodass nur die Abmessungen des dreidimensionalen Objekts skaliert werden.

6. Verfahren nach einem der vorgenannten Ansprüche, wobei in Abhängigkeit von den berechneten Koordinaten oder der berechneten Richtung des Permanentmagneten gleichzeitig mit der Steuerung der grafischen Schnittstelle eine von einem Menschen direkt wahrnehmbare Animation durchgeführt wird, um das konstruierte Bild entsprechend diesen berechneten Koordinaten oder der berechneten Richtung anzuzeigen.

7. Informationsaufzeichnungsträger (34), **dadurch gekennzeichnet, dass** er Anweisungen zur Ausführung eines Verfahrens gemäß einem der vorgenannten Ansprüche umfasst, wenn diese Anweisungen von einem elektronischen Computer ausgeführt werden.

8. Gerät zur Steuerung einer grafischen Schnittstelle zur Anzeige von Bildern eines dreidimensionalen Objekts, wobei dieses Gerät Folgendes umfasst:
- ein Netzwerk von Magnetometern, umfassend N triaxiale Magnetometer (Mᵢⱼ), die ohne jeglichen Freiheitsgrad mechanisch miteinander verbunden sind, um einen bekannten Abstand zwischen jedem dieser Magnetometer einzuhalten, wobei N eine ganze Zahl größer oder gleich fünf ist, wobei dieses Netzwerk von Magnetometern zugeordnet ist:
• einem dreidimensionalen Arbeitsbezugssystem, dessen Position gegenüber dem Netzwerk von Magnetometern bekannt ist, und
• einem vorbestimmten dreidimensionalen Messbereich,
- eine digitale Datei (36), die die Abmessungen des dreidimensionalen Objekts in einem sogenannten "virtuellen" dreidimensionalen Bezugssystem kodiert, wobei die Position des virtuellen Bezugssystems gegenüber dem Arbeitsbezugssystem bekannt ist, sodass die Koordinaten jedes Punkts des virtuellen Bezugssystems im Arbeitsbezugssystem durch einen Wechsel des Bezugssystems ausgedrückt werden können und umgekehrt,
- einen Zeiger (10) mit einem Permanentmagneten (14), der von einem Benutzer innerhalb des Messbereichs manuell bewegt werden kann,
- eine Verarbeitungseinheit (30), die programmiert ist um:
• die Messung des vom Permanentmagneten erzeugten Magnetfelds, die durch die Magnetometer des Netzwerks durchgeführt wurde, zu erfassen, wenn der Permanentmagnet innerhalb des Messbereichs angeordnet ist,
• die Koordinaten des Permanentmagneten und die Richtung des magnetischen Moments des Permanentmagneten in dem Arbeitsbezugssystem aus den Messungen der Magnetometer zu berechnen,
• die Abmessungen des dreidimensionalen Objekts den Koordinaten, die zuvor berechnet wurden zuzuordnen, indem jede Abmessung des dreidimensionalen Objekts mit einem Koeffizienten Cv multipliziert wird, um ein skaliertes dreidimensionales Objekt zu erhalten, und indem die Koordinaten multipliziert werden, die mit der Umkehrung eines Koeffizienten C_{R} berechnet wurden, um skalierte Koordinaten zu erhalten, wobei die Koeffizienten C_{V} und C_{R} so gewählt werden, dass das Verhältnis C_{V}/C_{R} gleich einem Koeffizienten Cₑ der Skala ist, wobei dieser Koeffizient Cₑ strikt niedriger als d_{z}/dₘₐₓ ist, wobei:
- dₘₐₓ der Abstand zwischen dem Ursprung des Arbeitsbezugssystems und dem Punkt des dreidimensionalen Objekts ist, der von diesem Ursprung entlang einer Messachse am weitesten entfernt ist, und
- d_{z} der Abstand zwischen dem Ursprung des Arbeitsbezugssystems und dem Punkt des Messbereichs ist, der von diesem Ursprung entlang derselben Messachse am weitesten entfernt ist, und
- die gewählte Messachse die Achse ist, die durch den Ursprung des Arbeitsbezugssystems verläuft und für die die Abweichung | dₘₐₓ - d_{z} | maximal ist,
• ein zweidimensionales Bild zu konstruieren, das dem Bild des skalierten Objekts entspricht, das aus einem Blickwinkel und entlang einer vorbestimmten optischen Achse betrachtet wird,
- wobei die Position des Blickwinkels aus den Koordinaten der Skala abgeleitet wird, und
- die Richtung der optischen Achse aus der gemessenen Richtung des magnetischen Moments des Permanentmagneten abgeleitet wird, und
• die grafische Benutzeroberfläche anzuweisen, das auf dieser grafischen Benutzeroberfläche konstruierte Bild anzuzeigen.

9. Gerät nach Anspruch 8, wobei das Gerät ein reales Modell (38) des dreidimensionalen Objekts umfasst, dessen Abmessungen gleich den Abmessungen des skalierten dreidimensionalen Objekts sind, wobei das Modell in dem Arbeitsbezugssystem an der gleichen Stelle wie das skalierte dreidimensionale Objekt platziert ist.

## Claims

1. Method for controlling a graphical interface for displaying images of a three-dimensional object, **characterized in that** this method comprises:
- the provision of an array of magnetometers comprising N three-axis magnetometers (Mᵢⱼ) mechanically connected to one another with no degree of freedom so as to conserve a known distance between each of these magnetometers, where N is an integer number greater than or equal to five, this array of magnetometers being associated:
• with a working three-dimensional reference frame whose position is known with respect to the array of magnetometers, and
• with a predetermined three-dimensional measurement area,
- the recording (52) of a digital file coding the dimensions of the three-dimensional object in a three-dimensional reference frame referred to as "virtual reference frame", the position of this virtual reference frame with respect to the working reference frame being known such that the coordinates of each point of the virtual reference frame may be expressed in the working reference frame by a change of reference frame,
- the provision of a pointer comprising a permanent magnet manually moveable by a user inside of the measurement area,
- when the permanent magnet is placed inside of the measurement area, the measurement (64), by the magnetometers of the array, of the magnetic field generated by the permanent magnet,
- the calculation (68) of the coordinates of the permanent magnet and of the direction of the magnetic moment of the permanent magnet in the working reference frame based on the measurements of the magnetometers,
- matching (70) the dimensions of the three-dimensional object with the coordinates previously calculated by multiplying each dimension of the three-dimensional object by a coefficient C_{V} so as to obtain a three-dimensional object brought to scale and by multiplying the coordinates calculated by the inverse of a coefficient C_{R} so as to obtain coordinates to scale, where the coefficients Cᵥ and C_{R} are chosen such that the ratio C_{V}/C_{R} is equal to a scaling coefficient Cₑ, this coefficient Cₑ being strictly less than d_{Z}/dₘₐₓ, where:
• dₘₐₓ is the distance between the origin of the working reference frame and the point of the three-dimensional object furthest from this origin along a measurement axis, and
• d_{Z} is the distance between the origin of the working reference frame and the point of the measurement area furthest from this origin along the same measurement axis,
• the measurement axis retained being the axis going through the origin of the working reference frame and for which the difference | dₘₐₓ - d_{Z} | is maximized,
- the construction (72) of an image in two dimensions corresponding to the image of the object brought to scale observed from a viewing point and along a predetermined optical axis,
• the position of the viewing point being deduced from the coordinates to scale, and
• the direction of the optical axis being deduced from the measured direction of the magnetic moment of the permanent magnet, and
- the control (74) of the graphical interface for displaying the image constructed on this graphical interface.

2. Method according to Claim 1, in which the method comprises the automatic determination (56) of the scaling coefficient Cₑ by automatically calculating the ratio d_{Z}/dₘₐₓ based on the dimensions of the three-dimensional object coded in the digital file and on the known dimensions of the measurement area, then by taking the value of the coefficient Cₑ equal to a*(d_{Z}/dₘₐₓ), where "a" is a pre-recorded constant.

3. Method according to Claim 1, in which the method comprises the automatic determination (56) of the scaling coefficient Cₑ based on a ratio between a dimension of the three-dimensional object coded in the digital file and of a known dimension of a model of this object contained inside of the measurement area.

4. Method according to either of Claims 2 and 3, in which, prior to the automatic determination of the scaling coefficient Cₑ, the method comprises the translation (54) of the coordinates of each point of the three-dimensional object into the virtual reference frame so that the geometric center of the translated three-dimensional object coincides with the geometric center of the measurement area and the determination of the coefficient Cₑ is carried out based on the dimensions of the three-dimensional object thus translated.

5. Method according to any one of the preceding claims, in which the coefficient C_{R} is systematically taken equal to one such that only the dimensions of the three-dimensional object are brought to scale.

6. Method according to any one of the preceding claims, in which, depending on the calculated coordinates or on the calculated direction of the permanent magnet, an animation directly visible to a human being is executed at the same time that a command is sent to the graphical interface for displaying the constructed image corresponding to these calculated coordinates or to this calculated direction.

7. Medium (34) for recording information, **characterized in that** it comprises instructions for the execution of a method according to any one of the preceding claims, when these instructions are executed by an electronic computer.

8. Device for controlling a graphical interface for displaying images of a three-dimensional object, this device comprising:
- an array of magnetometers comprising N three-axis magnetometers (Mᵢⱼ) mechanically connected to one another with no degree of freedom so as to conserve a known distance between each of these magnetometers, where N is an integer number greater than or equal to five, this array of magnetometers being associated:
• with a three-dimensional working reference frame whose position is known with respect to the array of magnetometers, and
• with a predetermined three-dimensional measurement area,
- a digital file (36) coding the dimensions of the three-dimensional object in a three-dimensional reference frame, referred to as a "virtual reference frame", the position of this virtual reference frame with respect to the working reference frame being known such that the coordinates of each point of the virtual reference frame may be expressed in the working reference frame by a change of reference frame and vice versa,
- a pointer (10) comprising a permanent magnet (14) manually moveable by a user inside of the measurement area,
- a processing unit (30) programmed for:
• when the permanent magnet is placed inside of the measurement area, acquiring the measurement, carried out by the magnetometers of the array, of the magnetic field generated by the permanent magnet,
• calculating coordinates of the permanent magnet and the direction of the magnetic moment of the permanent magnet in the working reference frame based on the measurements of the magnetometers,
• matching dimensions of the three-dimensional object with the coordinates previously calculated by multiplying each dimension of the three-dimensional object by a coefficient C_{V} so as to obtain a three-dimensional object brought to scale and by multiplying the calculated coordinates by the inverse of a coefficient C_{R} so as to obtain coordinates to scale, where the coefficients Cᵥ and C_{R} are chosen such that the ratio C_{V}/C_{R} is equal to a scaling coefficient Cₑ, this coefficient Cₑ being strictly less than d_{Z}/dₘₐₓ, where:
- dₘₐₓ is the distance between the origin of the working reference frame and the point of the three-dimensional object furthest from this origin along a measurement axis, and
- d_{Z} is the distance between the origin of the working reference frame and the point of the measurement area furthest from this origin along the same measurement axis,
- the measurement axis retained being the axis going through the origin of the working reference frame and for which the difference | dₘₐₓ - d_{Z} | is maximized,
• constructing an image in two dimensions corresponding to the image of the object brought to scale observed from a viewing point and along a predetermined optical axis,
- the position of the viewing point being deduced from the coordinates to scale, and
- the direction of the optical axis being deduced from the measured direction of the magnetic moment of the permanent magnet, and
• sending a command to the graphical interface for displaying the constructed image of the three-dimensional object on this graphical interface.

9. Device according to claim 8, in which the device comprises a real model (38) of the three-dimensional object whose dimensions are equal to the dimensions of the three-dimensional object brought to scale, this model being placed in the working reference frame at the same location as the three-dimensional object brought to scale.
